(19) Europäisches Patentamt / European Patent Office / Office européen des brevets

(11) **EP 3 057 136 A1**

(12) **EUROPEAN PATENT APPLICATION**
published in accordance with Art. 153(4) EPC

(43) Date of publication:
**17.08.2016  Bulletin 2016/33**

(51) Int Cl.:
**H01L 31/048** *(2006.01)*    **B32B 7/02** *(2006.01)*

(21) Application number: **14852412.7**

(86) International application number:
**PCT/JP2014/076948**

(22) Date of filing: **08.10.2014**

(87) International publication number:
**WO 2015/053314 (16.04.2015 Gazette 2015/15)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.10.2013   JP 2013212631**

(71) Applicant: **Mitsui Chemicals Tohcello, Inc.**
**Tokyo 101-8485 (JP)**

(72) Inventors:
• **ITO Tomoaki**
  **Sodegaura-shi**
  **Chiba 299-0265 (JP)**
• **TAKEUCHI Fumito**
  **Ichihara-shi**
  **Chiba 299-0108 (JP)**
• **IKENAGA Shigenobu**
  **Sodegaura-shi**
  **Chiba 299-0265 (JP)**
• **YARIMIZU Kazuhiro**
  **Sodegaura-shi**
  **Chiba 299-0265 (JP)**
• **OHSHIMIZU Kaoru**
  **Sodegaura-shi**
  **Chiba 299-0265 (JP)**

(74) Representative: **Hoffmann Eitle**
**Patent- und Rechtsanwälte PartmbB**
**Arabellastraße 30**
**81925 München (DE)**

(54)    **SHEET SET FOR SOLAR CELL ENCAPSULATION AND SOLAR CELL MODULE**

(57)     According to the present invention, there is provided a sheet set for encapsulating a solar cell which is disposed between a light-receiving surface side protective member and a back surface side protective member, and is used for encapsulating a solar cell element and a wiring material. The sheet set for encapsulating a solar cell includes a first encapsulating material sheet disposed on a light-receiving surface side and a second encapsulating material sheet disposed on a back surface side.

A storage elastic modulus ($P_1$) of the first encapsulating material sheet before a cross-linking treatment and a storage elastic modulus ($P_2$) of the second encapsulating material sheet before the cross-linking treatment satisfy a relationship of the following Expression (1), at 120°C when solid viscoelasticity is measured under conditions of a measurement temperature range of 25°C to 180°C, a frequency of 1.0 Hz, a temperature rising rate of 10°C/minute, and a shear mode.

$$\mathrm{Log}\,(P_1/P_2) > 0 \qquad \cdots\cdots \quad (1)$$

**(Cont. next page)**

Fig.1

**Description**

TECHNICAL FIELD

The present invention relates to a sheet set for encapsulating a solar cell, and a solar cell module.

BACKGROUND ART

Global environmental problems, energy problems, and the like become more serious, and thus a solar cell attracts attention as energy generation means that is clean and has no concern about exhaustion. In a case where a solar cell is used outside, for example, in the roof of a building, the solar cell is generally used in a form of solar cell modules.

Generally, a solar cell module is manufactured through the following procedure. Firstly, a crystalline solar cell element (which may be described below as a power generating element or a cell), a thin-film solar cell element, or the like is manufactured. The crystalline solar cell element is formed of polycrystalline silicon, single crystal silicon, and the like. The thin-film solar cell element is obtained by forming a very thin film of several $\mu$m on a substrate such as glass, using amorphous silicon or crystalline silicon.

Then, in order to obtain a crystalline solar cell module, a protective sheet for a solar cell module (light-receiving surface side protective member), an encapsulating material for solar cell, a crystalline solar cell element, an encapsulating material for solar cell, and a protective sheet for a solar cell module (back surface side protective member) are stacked in this order.

In order to obtain a thin-film type solar cell module, a thin-film solar cell element, an encapsulating material for solar cell, and a protective sheet for a solar cell module (back surface side protective member) are stacked in this order.

Then, a solar cell module is manufactured by using a lamination method in which vacuum aspiration is performed on the above components, and thermal press bonding is performed. The solar cell module manufactured in this manner has weather resistant, and is suitable for being used outside, for example, in the roof of a building.

An ethylene-vinyl acetate copolymer (EVA) film as an encapsulating material for solar cell is excellent in transparency, flexibility, adhesiveness, and the like, and thus is widely used. For example, Patent Document 1 discloses an encapsulating film which is formed of an EVA composition containing a cross-linking agent and trimellitic acid ester, and is excellent in both of adhesiveness and film forming properties.

Using a polyolefin-based material, particularly, an ethylene-based material as the encapsulating material for solar cell has been proposed from a viewpoint of excellent insulating properties (for example, see Patent Document 2).

A resin composition for the encapsulating material for solar cell, which uses an ethylene·$\alpha$-olefin copolymer has been also proposed (for example, see Patent Document 3). In the resin composition, cross-linking is performed for a relatively short term and thus sufficient adhesive strength is obtained. The resin composition has excellent balance between rigidity and cross-linking characteristics.

Using glass as a protective member or a lightweight resin film is applied, and thus a situation in which an interconnector (wiring portion) between power generating elements is broken when the elements are used occurs more frequently than before. This is because a difference of a thermal expansion coefficient between the glass·lightweight resin film or the encapsulating material, and the metal interconnector is large. The interconnector cannot follow the contraction and expansion of the resin occurring by a difference of the temperature between day and night or a difference of the temperature between seasons. The contraction and expansion are repeated and thus the interconnector is bent, and is broken in the worst case. In order to avoid such a risk of breaking the interconnector, various methods have been proposed thus far (for example, Patent Document 4).

RELATED DOCUMENT

PATENT DOCUMENT

[Patent Document 1] Japanese Laid-open Patent Publication No. 2010-53298
[Patent Document 2] Japanese Laid-open Patent Publication No. 2006-210906
[Patent Document 3] Pamphlet of International Publication No. WO 2011/162324
[Patent Document 4] Japanese Laid-open Patent Publication No. 2001-352089

SUMMARY OF THE INVENTION

However, all the proposed methods have a purpose of improving a wiring material itself, and a method of reducing a breaking risk by improving the encapsulating material has not been known thus far.

Considering the above circumstances, the present invention is made to provide a sheet set for encapsulating a solar cell, which can suppress bending or fatigue of a wiring material of a solar cell module, and can avoid breaking of a wiring material, and to provide a solar cell module using the sheet set for encapsulating a solar cell.

The present inventors closely investigated design guidelines for achieving the above objects. As a result, the present inventors recognized that an index obtained by applying a common logarithm to a ratio of a storage elastic modulus at high temperature between a first encapsulating material sheet disposed on a light-receiving surface side, and a second encapsulating material sheet disposed on a back surface side is effective as design guidelines for achieving the above objects, and thus, the present invention is deducted.

That is, according to the present invention, a sheet set for encapsulating a solar cell and a solar cell module, which are described in the following descriptions are provided.

[1] There is provided a sheet set for encapsulating a solar cell which is disposed between a light-receiving surface side protective member and a back surface side protective member, and is used for encapsulating a solar cell element and a wiring material. The sheet set for encapsulating a solar cell includes a first encapsulating material sheet disposed on a light-receiving surface side and a second encapsulating material sheet disposed on a back surface side.

In the sheet set for encapsulating a solar cell, a storage elastic modulus ($P_1$) of the first encapsulating material sheet before a cross-linking treatment and a storage elastic modulus ($P_2$) of the second encapsulating material sheet before the cross-linking treatment satisfy a relationship of the following Expression (1), at 120°C when solid viscoelasticity is measured under conditions of a measurement temperature range of 25°C to 180°C, a frequency of 1.0 Hz, a temperature rising rate of 10°C/minute, and a shear mode.

$$Log\ (P_1/P_2) > 0 \qquad \cdots\cdots \quad (1)$$

[2] In the sheet set for encapsulating a solar cell in [1], a storage elastic modulus ($G_1$), at 90°C when the solid viscoelasticity is measured under the conditions of the measurement temperature range of 25°C to 180°C, the frequency of 1.0 Hz, the temperature rising rate of 10°C/minute, and the shear mode, of the first encapsulating material sheet after the cross-linking treatment, a linear expansion coefficient ($\alpha_1$) at a range of -40°C to 0°C of the first encapsulating material sheet after the cross-linking treatment, and a linear expansion coefficient ($\alpha_2$) at a range of 50°C to 90°C of the first encapsulating material sheet after the cross-linking treatment, satisfy a relationship of the following Expression (2).

$$G_1 \times (\alpha_1/\alpha_2) \geqq 2 \times 10^4 \qquad \cdots\cdots \quad (2)$$

[3] In the sheet set for encapsulating a solar cell in [1] or [2], the first encapsulating material sheet after the cross-linking treatment and the second encapsulating material sheet after the cross-linking treatment respectively have a thickness of 0.2 mm to 1 mm.

[4] In the sheet set for encapsulating a solar cell in any one of [1] to [3], at least one of the first encapsulating material sheet and the second encapsulating material sheet contains one or two types or more selected from a group consisting of an ethylene·$\alpha$-olefin copolymer and an ethylene-vinyl acetate copolymer as a cross-linkable resin.

[5] In the sheet set for encapsulating a solar cell in [4], at least one of the first encapsulating material sheet and the second encapsulating material sheet contains organic peroxide, and the content of the organic peroxide is equal to or greater than 0.1 parts by mass and equal to or smaller than 1.2 parts by mass with respect to 100 parts by mass of the cross-linkable resin.

[6] In the sheet set for encapsulating a solar cell in any one of [1] to [5], the storage elastic modulus ($P_1$) is equal to or greater than $1.0 \times 10^{-1}$ Pa and equal to or smaller than $1.2 \times 10^6$ Pa, and the storage elastic modulus ($P_2$) is equal to or greater than $8.0 \times 10^{-2}$ Pa and equal to or smaller than $1.0 \times 10^6$ Pa.

[7] In the sheet set for encapsulating a solar cell in any one of [1] to [6], the light-receiving surface side protective member is a glass plate, and the back surface side protective member is a thermoplastic resin film.

[8] There is provided a solar cell module which uses the sheet set for encapsulating a solar cell in any one of [1] to [7].

[9] In the solar cell module in [8], an encapsulating layer is provided between the light-receiving surface side protective member and the back surface side protective member, and the solar cell element is encapsulated in the encapsulating layer, and the encapsulating layer is formed by the sheet set for encapsulating a solar cell. The encapsulating layer includes a first encapsulating layer and a second encapsulating layer. The first encapsulating layer is obtained by cross-linking the first encapsulating material sheet, and the second encapsulating layer is obtained by cross-linking the second encapsulating material sheet. The first encapsulating layer is provided between the light-receiving surface side protective member and the solar cell element, and the second encapsulating layer is provided between the back surface side protective member and the solar cell element.

[10] In the solar cell module in [9], the light-receiving surface side protective member is a glass plate, and the back surface side protective member is a thermoplastic resin film.

According to the present invention, it is possible to provide a sheet set for encapsulating a solar cell which can suppress application of stress to a solar cell element or a wiring material when a solar cell module is manufactured, and also suppress occurrence of cracks in the solar cell element or breaking of the wiring material.

Further, according to the present invention, it is possible to provide a solar cell module which causes reception of an influence of a temperature cycle to be difficult.

BRIEF DESCRIPTION OF THE DRAWINGS

The object and other objects, features and advantages which are described above are clarified by a desired embodiment which will be described below, and the following accompanying drawings.

FIG. 1 is a schematic cross-sectional view illustrating an embodiment of a solar cell module according to the present invention.

FIG. 2 is a schematic cross-sectional view illustrating a stacked body used in evaluation of a bent amount in examples and comparative examples.

FIG. 3 is a schematic cross-sectional view illustrating a pseudo module which is used in a temperature cycle test, in the examples and the comparative examples.

FIG. 4 is a schematic front view illustrating the pseudo module which is used in a temperature cycle test, in the examples and the comparative examples.

DESCRIPTION OF EMBODIMENTS

Hereinafter, an embodiment according to the present invention will be described with reference to the drawings. In all of the drawings, similar components are denoted by the similar reference numerals and descriptions thereof will be not repeated. "A to B" in a numerical range means being equal to or greater than A and equal to or smaller than B as long as there is no particular statement about "A to B".

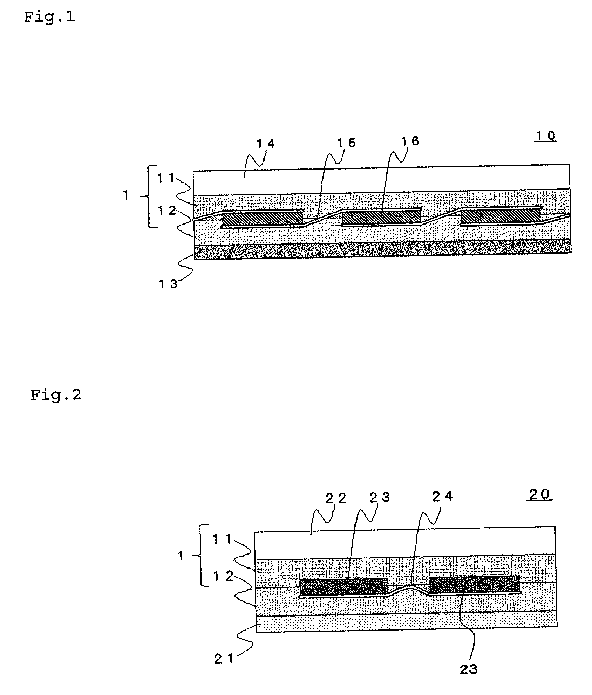

FIG. 1 is a schematic cross-sectional view illustrating an embodiment of a solar cell module 10 according to the present invention.

The solar cell module 10 according to the embodiment includes an encapsulating layer 1, a light-receiving surface side protective member 14, a back surface side protective member 13, a solar cell element 16, and a wiring material (interconnector) 15. The encapsulating layer 1 is formed from a pair of sheets for encapsulating a solar cell, that is, a first encapsulating material sheet 11 disposed on a light-receiving surface side, and a second encapsulating material sheet 12 disposed on a back surface side.

In the embodiment, the first encapsulating material sheet 11 and the second encapsulating material sheet 12 are also collectively referred to as "first and second encapsulating material sheets".

Hereinafter, the sheet set for encapsulating a solar cell and a solar cell module will be described.

<Sheet set for encapsulating a solar cell>

The sheet set for encapsulating a solar cell according to the embodiment is disposed between the light-receiving surface side protective member 14 and the back surface side protective member 13, and is used for encapsulating the solar cell element 16 and the wiring material 15. The sheet set for encapsulating a solar cell includes the first encapsulating material sheet 11 disposed on the light-receiving surface side and the second encapsulating material sheet 12 disposed on the back surface side. A relationship between a storage elastic modulus ($P_1$) of the first encapsulating material sheet 11 and a storage elastic modulus ($P_2$) of the second encapsulating material sheet 12 at 120°C when solid viscoelasticity is measured under conditions of a measurement temperature range of 25°C to 180°C, a frequency of 1.0 Hz, a temperature rising rate of 10°C/minute, and a shear mode satisfy a relationship of the following Expression (1) . A relationship of Expression (1a) is more preferably satisfied, and a relationship of Expression (1b) is further preferably satisfied.

$$\text{Log } (P_1/P_2) > 0 \qquad \cdots \cdots (1)$$

$$\text{Log } (P_1/P_2) > 0.1 \qquad \cdots \cdots (1a)$$

$$\text{Log } (P_1/P_2) > 0.2 \qquad \cdots \cdots (1b)$$

When a value of common logarithm of $(P_1/P_2)$ is more than the lower limit value, it is possible to provide a solar cell module which reduces the load applied to the solar cell element or the wiring material by the first and second encapsulating material sheets when the solar cell module is manufactured, further suppresses cracks of the solar cell element and breaking of the wiring material, and is stable for a temperature cycle. The relationship preferably satisfies the following Expression (1c). When the value of the common logarithm of $(P_1/P_2)$ is equal to or smaller than the upper limit value, it is possible to suppress damage or poor bonding of the solar cell element occurring when the solar cell module is manufactured, due to a very large difference between the elastic moduli.

$$\text{Log } (P_1/P_2) \leqq 2 \qquad \cdots \cdots (1c)$$

The storage elastic modulus $(P_1)$ of the first encapsulating material sheet 11 before a cross-linking treatment, at 120°C when solid viscoelasticity is measured under conditions of the measurement temperature range of 25°C to 180°C, the frequency of 1.0 Hz, the temperature rising rate of 10°C/minute, and the shear mode is preferably $1.0 \times 10^{-1}$ Pa to $1.2 \times 10^6$ Pa, more preferably $1.0 \times 10^{\circ}$ Pa to $1.2 \times 10^5$ Pa, and further preferably $1.0 \times 10^0$ Pa to $1.2 \times 10^4$ Pa. When the storage elastic modulus $(P_1)$ is in the above range, it is possible to provide a solar cell module which further reduces the load applied to the solar cell element or the wiring material by the first and second encapsulating material sheets when the solar cell module is manufactured, further suppresses cracks of the solar cell element or breaking of the wiring material, and causes reception of an influence of the temperature cycle to be further difficult.

The storage elastic modulus $(P_2)$ of the second encapsulating material sheet 12 before the cross-linking treatment, at 120°C when solid viscoelasticity is measured under conditions of the measurement temperature range of 25°C to 180°C, the frequency of 1.0 Hz, the temperature rising rate of 10°C/minute, and the shear mode is preferably $8.0 \times 10^{-2}$ Pa to $1.0 \times 10^6$ Pa, more preferably $8.0 \times 10^{-1}$ Pa to $1.0 \times 10^5$ Pa, and further preferably $1.0 \times 10^0$ Pa to $1.0 \times 10^4$ Pa. When the storage elastic modulus $(P_2)$ is in the above range, it is possible to provide a solar cell module which further reduces the load applied to the solar cell element or the wiring material by the first and second encapsulating material sheets when the solar cell module is manufactured, further suppresses cracks of the solar cell element or breaking of the wiring material, and causes reception of an influence of the temperature cycle to be further difficult.

In the sheet set for encapsulating a solar cell according to the embodiment, a storage elastic modulus $(G_1)$ of the first encapsulating material sheet 11, after the cross-linking treatment disposed on the light-receiving surface side, at 90°C when the solid viscoelasticity is measured under the conditions of the measurement temperature range of 25°C to 180°C, the frequency of 1.0 Hz, the temperature rising rate of 10°C/minute, and the shear mode, a linear expansion coefficient $(\alpha_1)$ of the first encapsulating material sheet 11 at a range of -40°C to 0°C, after the cross-linking treatment, and a linear expansion coefficient $(\alpha_2)$ of the first encapsulating material sheet 11 at a range of 50°C to 90°C, after the cross-linking treatment, preferably satisfy Expression (2). The storage elastic modulus $(G_1)$, the linear expansion coefficient $(\alpha_1)$, and the linear expansion coefficient $(\alpha_2)$ more preferably satisfy Expression (2a), and further preferably satisfy Expression (2b). When $G_1$ and $(\alpha_1/\alpha_2)$ satisfy Expression (2), it is possible to provide a solar cell module which causes reception of the influence of the temperature cycle to be further difficult. Here, a unit of $G_1 \times (\alpha_1/\alpha_2)$ is "Pa".

$$G_1 \times (\alpha_1/\alpha_2) \geqq 2 \times 10^4 \qquad \cdots \cdots (2)$$

$$G_1 \times (\alpha_1 / \alpha_2) \geqq 4 \times 10^4 \quad \cdots\cdots \quad (2a)$$

$$G_1 \times (\alpha_1 / \alpha_2) \geqq 5 \times 10^4 \quad \cdots\cdots \quad (2b)$$

Preferably, the storage elastic modulus ($G_1$), the linear expansion coefficient ($\alpha_1$), and the linear expansion coefficient ($\alpha_2$) satisfy Expression (2c). When the storage elastic modulus ($G_1$), the linear expansion coefficient ($\alpha_1$), and the linear expansion coefficient ($\alpha_2$) are in the above range, it is possible to provide a solar cell module which further reduces the load applied to the solar cell element or the wiring material by the first and second encapsulating material sheets when the solar cell module is manufactured, further suppresses cracks of the solar cell element or breaking of the wiring material, and causes reception of an influence of the temperature cycle to be further difficult.

$$G_1 \times (\alpha_1 / \alpha_2) < 2 \times 10^5 \quad (2c)$$

The storage elastic modulus ($G_1$) of the first encapsulating material sheet 11 after the cross-linking treatment, at 90°C when the solid viscoelasticity is measured under the conditions of the measurement temperature range of 25°C to 180°C, the frequency of 1.0 Hz, the temperature rising rate of 10°C/minute, and the shear mode is preferably $1.0 \times 10^3$ Pa to $1.0 \times 10^9$ Pa, more preferably $1.0 \times 10^4$ Pa to $1.0 \times 10^8$ Pa, and further preferably $1.0 \times 10^4$ Pa to $1.0 \times 10^7$ Pa. When the storage elastic modulus ($G_1$) is in the above range, it is possible to provide a solar cell module which further suppresses cracks of the solar cell element or breaking of the wiring material, and causes reception of an influence of the temperature cycle to be further difficult.

The linear expansion coefficient ($\alpha_1$) of the first encapsulating material sheet 11 after the cross-linking treatment, at a range of -40°C to 0°C is preferably $1 \times 10^{-6}$/°C to $5000 \times 10^{-6}$/°C, more preferably $10 \times 10^{-6}$/°C to $1000 \times 10^{-6}$/°C, and further preferably $10 \times 10^{-6}$/°C to $500 \times 10^{-6}$/°C.

The linear expansion coefficient ($\alpha_2$) of the first encapsulating material sheet 11 after the cross-linking treatment, at a range of 50°C to 90°C is preferably $1 \times 10^{-6}$/°C to $5000 \times 10^{-6}$/°C, more preferably $10 \times 10^{-6}$/°C to $1000 \times 10^{-6}$/°C, and further preferably $10 \times 10^{-6}$/°C to $500 \times 10^{-6}$/°C. When the linear expansion coefficient ($\alpha_2$) is in the above range, it is possible to provide a solar cell module which further suppresses cracks of the solar cell element or breaking of the wiring material, and causes reception of an influence of the temperature cycle to be further difficult.

The storage elastic modulus ($P_1$), the storage elastic modulus ($P_2$), the storage elastic modulus ($G_1$), the linear expansion coefficient ($\alpha_1$), and the linear expansion coefficient ($\alpha_2$) may be controlled by respectively adjusting, for example, the type or a mixing ratio of a cross-linkable resin, a cross-linking agent, a crosslinking aid, and the like which are contained in the first and second encapsulating material sheets, the molecular weight, MFR, or density of the cross-linkable resin, porosity P of the first and second encapsulating material sheets, and the like.

(Cross-linkable resin)

The sheet set for encapsulating a solar cell according to the embodiment includes the first encapsulating material sheet 11 disposed on the light-receiving surface side, and the second encapsulating material sheet 12 disposed on the back surface side. The first and second encapsulating material sheets contain a cross-linkable resin, generally.

As the cross-linkable resin, the conventional well-known resin may be used. For example, one or two types or more selected from the following materials may be used: ethylene·$\alpha$-olefin copolymers containing ethylene and $\alpha$-olefin having 3 to 20 carbon atoms; high-density ethylene-based resins; low-density ethylene-based resins; medium-density ethylene-based resins; ultra low-density ethylene-based resins; olefin-based resins such as propylene (co)polymers, 1-butene (co)polymers, 4-methylpentene-1 (co)polymers, ethylene·cyclic olefin copolymers, ethylene·$\alpha$-olefin·cyclic olefin copolymers, ethylene·$\alpha$-olefin-nonconjugated polyene copolymers, ethylene·$\alpha$olefin-conjugated polyene copolymers, ethylene·aromatic vinyl copolymers, and ethylene·$\alpha$-olefin·aromatic vinyl copolymers; ethylene·carboxylic acid anhydride copolymers such as ethylene·unsaturated carboxylic acid anhydride copolymers and ethylene·$\alpha$-olefin·unsaturated carboxylic acid anhydride copolymers; ethylene·epoxy-based copolymers such as ethylene·epoxy-containing unsaturated compound copolymers and ethylene·$\alpha$-olefin·epoxy-containing unsaturated compound copolymers; ethylene·vinyl ester copolymers such as ethylene-vinyl acetate copolymers; ethylene·unsaturated carboxylic acid copolymers such as ethylene·acrylic acid copolymers, and ethylene·methacryic acid copolymers; ethylene·unsaturated carboxylic acid ester copolymers such as ethylene·ethyl acrylate copolymers, and ethylene·methyl methacrylate copolymers; unsaturated carboxylic acid ester (co)polymers such as (meta) acrylic acid ester (co) polymers; ionomer resins such as ethylene·acrylic acid metal salt copolymers, and ethylene·methacrylic acid metal salt copolymers; urethane-based resins; silicone-based resins; acrylic acid-based resins; methacrylic acid-based resins; cyclic olefin (co)polymers; α-olefin-aromatic vinyl compound·aromatic polyene copolymers; ethylene-α-olefin·aromatic vinyl compound·aromatic polyene copolymers; ethylene·aromatic vinyl compound·aromatic polyene copolymers; styrene-based resins; styrene-based copolymer resins such as acrylonitrile·butadiene·styrene copolymers, styrene·conjugated diene copolymers, acrylonitrile·styrene copolymers, acrylonitrile·ethylene·α-olefin·nonconjugated polyene·styrene copolymers, acrylonitrile·ethylene·α-olefin·conjugated polyene·styrene copolymers, and methacrylic acid·styrene copolymers; ethylene terephthalate resins; fluorine resins; polyester carbonates; chlorine-based resins such as polyvinyl chloride and polyvinylidene chloride; thermoplastic elastomers such as polyolefin-based thermoplastic elastomers, polystyrene-based thermoplastic elastomers, polyurethane-based thermoplastic elastomers, 1,2-polybutadiene-based thermoplastic elastomers, trans-polyisoprene-based thermoplastic elastomers, and chlorinated polyethylene-based thermoplastic elastomers; liquid crystalline polyesters; and polylactic acids.

Among these materials, one or two types or more selected from the following materials which enable cross-linking by using organic peroxide and the like is preferably used: ethylene·α-olefin copolymers formed of ethylene and α-olefin having 3 to 20 carbon atoms; low-density ethylene-based resins; medium-density ethylene-based resins; ultra low-density ethylene-based resins; olefin-based resins such as ethylene·cyclic olefin copolymers, ethylene·α-olefin·cyclic olefin copolymers, ethylene·α-olefin-nonconjugated polyene copolymers, ethylene·α-olefin-conjugated polyene copolymers, ethylene·aromatic vinyl copolymers, and ethylene·α-olefin·aromatic vinyl copolymers; ethylene·carboxylic acid anhydride copolymers such as ethylene·unsaturated carboxylic acid anhydride copolymers and ethylene·α-olefin·unsaturated carboxylic acid anhydride copolymers; ethylene·epoxy-based copolymers such as ethylene·epoxy-containing unsaturated compound copolymers and ethylene·α-olefin·epoxy-containing unsaturated compound copolymers; ethylene·vinyl ester copolymers such as ethylene·vinyl acetate copolymers; ethylene·unsaturated carboxylic acid copolymers such as ethylene·acrylic acid copolymers, and ethylene·methacryic acid copolymers; and 1,2-polybutadiene-based thermoplastic elastomers.

Further, one or two types or more selected from the following materials is preferably used: ethylene·α-olefin copolymers formed of ethylene and α-olefin having 3 to 20 carbon atoms, low-density ethylene-based resins, ultra low-density ethylene-based resins, ethylene·α-olefin·nonconjugated polyene copolymers, ethylene·α-olefin·conjugated polyene copolymers, ethylene·unsaturated carboxylic acid anhydride copolymers, ethylene·α-olefin·unsaturated carboxylic acid anhydride copolymers, ethylene·epoxy-containing unsaturated compound copolymers, ethylene·α-olefin·epoxy-containing unsaturated compound copolymers, ethylene-vinyl acetate copolymers, ethylene·acrylic acid copolymers, and ethylene·methacryic acid copolymers.

Particularly, one or two types or more selected from the following materials is preferably used: ethylene·α-olefin copolymers formed of ethylene and α-olefin having 3 to 20 carbon atoms, low-density ethylene-based resins, ultra low-density ethylene-based resins, ethylene·α-olefin·nonconjugated polyene copolymers, ethylene·α-olefin·conjugated polyene copolymers, ethylene-vinyl acetate copolymers, ethylene·acrylic acid copolymers, and ethylene·methacryic acid copolymers. It is particularly preferable that at least one type selected from ethylene·α-olefin copolymers and ethylene-vinyl acetate copolymers is used among these materials. The above-described resins in the embodiment may be singly used or may be blended and used.

In a case where at least one type selected from ethylene·α-olefin copolymer and ethylene-vinyl acetate copolymer is contained as the cross-linkable resin, the content of the resin selected from ethylene·α-olefin copolymer and ethylene-vinyl acetate copolymer, in the first and second encapsulating material sheets is preferably equal to or greater than 80 mass%, more preferably equal to or greater than 90 mass%, further preferably equal to or greater than 95 mass%, that is, preferably 100 mass% when the entirety of resin components included in the first and second encapsulating material sheets is set to 100 mass%. Thus, it is possible to obtain the first and second encapsulating material sheets which are excellent in balance between characteristics such as transparency, adhesiveness, thermal resistance, flexibility, cross-linking characteristics, electrical characteristics, and the like.

(Ethylene·α-olefin copolymer)

As the α-olefin of ethylene·α-olefin copolymer which is used as the cross-linkable resin and is formed of ethylene and α-olefin having 3 to 20 carbon atoms, generally, one type of α-olefin having 3 to 20 carbon atoms may be singly used or combination of two types or more may be used. Among these materials, α-olefin having carbon atoms of 10 or less is preferable, and α-olefin having 3 to 8 carbon atoms is particularly preferable. Specific examples of such α-olefin may include propylene, 1-butene, 1-pentene, 1-hexene, 3-methyl-1-butene, 3,3-dimethyl-1-butene, 4-methyl-1-pentene, 1-octene, 1-decene, and 1-dodecene. Among these materials, from a viewpoint of easy acquisition, one or two types or more selected from propylene,1-butene, 1-pentene, 1-hexene, 4-methyl-1-pentene, and 1-octene is preferably used. The ethylene·$\alpha$-olefin copolymer may be a random copolymer or a block copolymer. However, from a viewpoint of flexibility, random copolymer is preferable.

The ethylene·$\alpha$-olefin copolymer may be polymerized by using any of vapor phase polymerization, and liquid phase polymerization such as slurry polymerization and solution polymerization, which have been conventionally known well. The ethylene·$\alpha$-olefin copolymer may be polymerized by using the conventional well-known catalysts for olefin polymerization such as a metallocene catalyst, a Ziegler-Natta catalyst, and vanadium catalyst.

The ethylene·$\alpha$-olefin copolymer may be a copolymer formed of ethylene, $\alpha$-olefin having 3 to 20 carbon atoms, and non-conjugated polyene. $\alpha$-olefin is similar to the above descriptions. Examples of non-conjugated polyene include 5-ethylidene-2-norbornene (ENB), 5-vinyl-2-norbornene (VNB), and dicyclopentadiene (DCPD). Such non-conjugated polyene may be singly used or be used in combination of two types or more.

Preferably, the ethylene·$\alpha$-olefin copolymer satisfies the following requirements a1 and a2.

Requirement a1: density of the ethylene·$\alpha$-olefin copolymer, which is measured based on ASTM D1505 is preferably 0.865 g/cm$^3$ to 0.884 g/cm$^3$, more preferably 0.866 g/cm$^3$ to 0.883 g/cm$^3$, further preferably 0.866 g/cm$^3$ to 0.880 g/cm$^3$, and particularly preferably 0.867 g/cm$^3$ to 0.880 g/cm$^3$.

The density of the ethylene·$\alpha$-olefin copolymer may be adjusted in accordance with balance between a content ratio of an ethylene unit and a content ratio of an $\alpha$-olefin unit. That is, when the content ratio of the ethylene unit is increased, crystallinity is increased, and thus an ethylene·$\alpha$-olefin copolymer having high density may be obtained. When the content ratio of the ethylene unit is decreased, the crystallinity is lowered, and thus an ethylene·$\alpha$-olefin copolymer having low density may be obtained.

When the density of the ethylene·$\alpha$-olefin copolymer is equal to or smaller than the upper limit value, the crystallinity is lowered, and thus transparency may be improved. Further, extrusion molding at a low temperature may be easily performed. For example, extrusion molding may be performed at a temperature of 130°C or lower. Thus, even when organic peroxide is kneaded and added to the ethylene·$\alpha$-olefin copolymer, it is possible to prevent proceeding of a cross-linking reaction in an extruder, to suppress generation of a gelatinous foreign material in the sheet, and to suppress poor appearance of the sheet.

When the density of the ethylene·$\alpha$-olefin copolymer is equal to or greater than the lower limit value, the crystallization rate of the ethylene·$\alpha$-olefin copolymer can be increased. Thus, occurring of stickiness of a sheet extruded by an extruder is difficult, the sheet is easily separated from a cooling roll, and it is possible to easily obtain the first and second encapsulating material sheets. Since occurring of the stickiness on the sheet is difficult, it is possible to suppress occurrence of blocking and to improve feeding properties of a sheet. Since cross-linking is sufficiently performed, it is possible to suppress deterioration of thermal resistance.

Requirement a2: melting flow rate (MFR) of the ethylene·$\alpha$-olefin copolymer, which is measured under conditions of a temperature of 190°C, and a load of 2.16 kg, based on ASTM D1238 is generally 0.1 g/10 minutes to 50 g/10 minutes. The MFR is preferably 2 g/10 minutes to 40 g/10 minutes, more preferably 2 g/10 minutes to 30 g/10 minutes, and further preferably 5 g/10 minutes to 10 g/10 minutes.

The MFR of the ethylene·$\alpha$-olefin copolymer may be adjusted by adjusting a polymerization temperature, polymerization pressure when a polymerization reaction is performed, along with a molar ratio and the like of monomer concentration and hydrogen concentration of ethylene and $\alpha$-olefin in a polymerization system.

When the MFR is equal to or greater than 0.1 g/10 minutes and smaller than 10 g/10 minutes, a sheet may be manufactured by calendered molding. When the MFR is equal to or greater than 0.1 g/10 minutes and smaller than 10 g/10 minutes, fluidity of a resin composition containing the ethylene·$\alpha$-olefin copolymer is low. Thus, the above MFR range is preferable from a point that contamination of a laminating device by a molten resin protruded when the sheet is laminated with a battery cell element can be prevented.

When the MFR is equal to or greater than 2 g/10 minutes, and preferably equal to or greater than 10 g/10 minutes, it is possible to improve the fluidity of the resin composition containing the ethylene·$\alpha$-olefin copolymer, and to improve productivity when extrusion molding is performed for a sheet. When the MFR is equal to or smaller than 50 g/10 minutes, the molecular weight of the composition is increased, and thus it is possible to suppress adhering to a roll surface of a chill roll and the like, and to mold a sheet having a uniform thickness, without a need for separation. Since a resin composition having "stiffness" is formed, it is possible to easily mold a sheet having a thickness which is equal to or greater than 0.1 mm. Since cross-linking characteristics when laminate molding is performed for a solar cell module are improved, it is possible to sufficiently perform cross-linking and to suppress deterioration of the thermal resistance. When the MFR is equal to or smaller than 27 g/10 minutes, it is possible to mold a sheet having a wide width which allows drawdown when the sheet is molded, to be suppressed. It is possible to further improve the cross-linking characteristics and the thermal resistance, and to obtain the best first and second encapsulating material sheets.

In a laminate process of a solar cell module, in a case where the cross-linking treatment is not performed on the first and second encapsulating material sheets, an influence of decomposition of organic peroxide in a melting and extruding process is small. Thus, it is possible to obtain a sheet by performing extrusion molding with a resin composition of which the MFR is equal to or greater than 0.1 g/10 minutes and smaller than 10 g/10 minutes, and preferably equal to or greater than 0.5 g/10 minutes and smaller than 8.5 g/10 minutes. When the content of organic peroxide in the resin composition is equal to or smaller than 0.15 parts by mass, a sheet may be manufactured at a molding temperature of 170°C to 250°C by performing extrusion molding with a resin composition of which the MFR is equal to or greater than 0.1 g/10 minutes and smaller than 10 g/10 minutes, while a silane modification treatment or a minute cross-linking treatment is performed. When the MFR is in the above range, contamination of a laminating device by a molten resin protruded when the sheet is laminated with a solar cell element can be prevented, and thus the above MFR range is preferable.

Preferably, the ethylene·α-olefin copolymer further satisfies the following requirement a3.

Requirement a3: the content of a constituent unit (also described as "an ethylene unit" below) which is contained in the ethylene·α-olefin copolymer and is derived from ethylene is equal to or greater than 80 mol% and equal to or smaller than 90 mol%, preferably equal to or greater than 80 mol% and equal to or smaller than 88 mol%, more preferably equal to or greater than 82 mol% and equal to or smaller than 88 mol%, further preferably equal to or greater than 82 mol% and equal to or smaller than 87 mol%. The content of a constituent unit (also described as "an α-olefin unit" below) which is contained in the ethylene·α-olefin copolymer and is derived from α-olefin having 3 to 20 carbon atoms is equal to or greater than 10 mol% and equal to or smaller than 20 mol%, preferably equal to or greater than 12 mol% and equal to or smaller than 20 mol%, more preferably equal to or greater than 12 mol% and equal to or smaller than 18 mol%, further preferably equal to or greater than 13 mol% and equal to or smaller than 18 mol%.

When the content of the α-olefin unit contained in the ethylene·α-olefin copolymer is equal to or greater than the lower limit value, the first and second encapsulating material sheets which are obtained at this time have excellent transparency. It is possible to easily perform extrusion molding at a low temperature, for example, perform extrusion molding at a temperature of 130°C or lower. Thus, even when organic peroxide is kneaded and added to the ethylene·α-olefin copolymer, it is possible to prevent proceeding of the cross-linking reaction in the extruder, to suppress generation of a gelatinous foreign material in the first and second encapsulating material sheets, and to suppress poor appearance of the sheet. In addition, since appropriate flexibility is obtained, it is possible to prevent occurrence of cracks in a solar cell element, and generation of shards and the like of a thin film electrode when laminate molding is performed for the solar cell module.

When the content of the α-olefin unit contained in the ethylene·α-olefin copolymer is equal to or smaller than the upper limit value, the crystallization rate of the ethylene·α-olefin copolymer is appropriate. Thus, a sheet extruded by the extruder is not sticky and is easily separated from the cooling roll. Accordingly, it is possible to effectively obtain the first and second encapsulating material sheets. Since the stickiness does not occur on the sheet, it is possible to prevent blocking and to improve feeding properties of the sheet. In addition, it is possible to suppress deterioration of thermal resistance of the first and second encapsulating material sheets.

(Ethylene-vinyl acetate copolymer)

The melting flow rate (MFR) of an ethylene-vinyl acetate copolymer which is used as the cross-linkable resin is preferably 5 g/10 minutes to 50 g/10 minutes, more preferably 5 g/10 minutes to 30 g/10 minutes, and further preferably 5 g/10 minutes to 25 g/10 minutes. When the MFR of the ethylene-vinyl acetate copolymer is in the above range, extrusion molding properties are excellent. The MFR of the ethylene-vinyl acetate copolymer may be adjusted by adjusting a polymerization temperature, polymerization pressure when a polymerization reaction is performed, along with a molar ratio and the like of monomer concentration of polar monomers, and hydrogen concentration in a polymerization system.

In the embodiment, the MFR of the ethylene-vinyl acetate copolymer is measured under conditions of a temperature of 190°C, and a load of 2.16 kg, based on ASTM D1238.

The content of vinyl acetate in the ethylene-vinyl acetate copolymer is preferably equal to or greater than 10 mass% and equal to or smaller than 47 mass%, and more preferably equal to or greater than 13 mass% and equal to or smaller than 35 mass%. When the content of vinyl acetate is in the above range, the first and second encapsulating material sheets have further excellent balance between adhesiveness, weather resistance, transparency, and mechanical properties. When the first and second encapsulating material sheets are formed, good film formation properties are obtained. The content of vinyl acetate may be measured based on JIS K7192:1999. Specifically, a sample is dissolved in xylene. After an acetic acid group is subjected to hydrolysis in an alcohol solution of potassium hydroxide, surplus sulfuric acid or hydrochloric acid is added. The resultant of the addition is dropped into a standard sodium hydroxide solution, the dropped amount is determined, and thereby, the content of vinyl acetate may be measured.

The ethylene-vinyl acetate copolymer is not particularly limited, and may be produced by a well-known method. For example, the ethylene-vinyl acetate copolymer may be produced by copolymerizing ethylene, vinyl acetate, and if necessary, other copolymer components at the atmospheric pressure of 500 to 4000, at a temperature of 100°C to 300°C, in a state where a radical generation agent is present, and a solvent or a chain transfer agent is present or absent.

In the embodiment, as the cross-linkable resin, either of the ethylene·α-olefin copolymer and the ethylene-vinyl acetate copolymer may be singly used or the ethylene·α-olefin copolymer and the ethylene-vinyl acetate copolymer may be blended and used. In a case where the ethylene·α-olefin copolymer and the ethylene-vinyl acetate copolymer are blended and used, with respect to the total amount of the ethylene·α-olefin copolymer and the ethylene-vinyl acetate copolymer, that is, 100 parts by mass, it is preferable that the ethylene·α-olefin copolymer is 50 parts by mass to 99 parts by mass, and the ethylene-vinyl acetate copolymer is 1 part by mass to 50 parts by mass. It is more preferable that the ethylene·α-olefin copolymer is 50 parts by mass to 98 parts by mass, and the ethylene-vinyl acetate copolymer is 2 parts by mass to 50 parts by mass. It is further preferable that the ethylene·α-olefin copolymer is 50 parts by mass to 95 parts by mass, and the ethylene-vinyl acetate copolymer is 5 parts by mass to 50 parts by mass. It is particularly preferable that the ethylene·α-olefin copolymer is 75 parts by mass to 95 parts by mass, and the ethylene-vinyl acetate copolymer is 5 parts by mass to 25 parts by mass.

(MFR ratio)

In the sheet set for encapsulating a solar cell according to the embodiment, the MFR of the cross-linkable resin contained in the first encapsulating material sheet 11 is preferably smaller than the MFR of the cross-linkable resin contained in the second encapsulating material sheet 12. Specifically, a MFR ratio is indicated by (the MFR of the cross-linkable resin contained in the first encapsulating material sheet 11) / (the MFR of cross-linkable resin contained in the second encapsulating material sheet 12). The MFR ratio is preferably smaller than 1.0, more preferably equal to or smaller than 0.8, and further preferably equal to or smaller than 0.6.

When the MFR ratio is in the above range, a relationship between the storage elastic modulus ($P_1$) and the storage elastic modulus ($P_2$) at 120°C satisfies the relationship of the above-described Expression (1). Bending of interconnector provided between the first and second encapsulating material sheets in a solar cell module is more unlikely to occur, and concentration of stress at the interconnector is more unlikely to occur.

(Vinyl acetate content)

In the sheet set for encapsulating a solar cell according to the embodiment, in a case where the ethylene-vinyl acetate copolymer is used for both of the first encapsulating material sheet 11 and the second encapsulating material sheet 12, the content of vinyl acetate in the first encapsulating material sheet 11 is preferably smaller than that in the second encapsulating material sheet 12.

Specifically, a VA ratio is indicated by (the content of vinyl acetate in the first encapsulating material sheet 11)/(the content of vinyl acetate in the second encapsulating material sheet 12). The VA ratio is preferably smaller than 1.0, and more preferably equal to or smaller than 0.9, and further preferably equal to or smaller than 0.8.

When the ratio of the content of vinyl acetate is in the above range, a relationship between the storage elastic modulus ($P_1$) and the storage elastic modulus ($P_2$) at 120°C satisfies the relationship of the above-described Expression (1). Bending of interconnector provided between the first and second encapsulating material sheets in a solar cell module is more unlikely to occur, and concentration of stress at the interconnector is more unlikely to occur.

In the sheet set for encapsulating a solar cell according to the embodiment, different materials from each other are preferably used for the first encapsulating material sheet 11 and the second encapsulating material sheet 12. Specifically, an embodiment in which the first encapsulating material sheet 11 contains an ethylene-vinyl acetate copolymer, and the second encapsulating material sheet 12 contains an ethylene·α-olefin copolymer, an embodiment in which the first encapsulating material sheet 11 contains an ethylene·α-olefin copolymer, and the second encapsulating material sheet 12 contains an ethylene-vinyl acetate copolymer, and the like may be exemplified. The embodiment in which the first encapsulating material sheet 11 contains an ethylene-vinyl acetate copolymer, and the second encapsulating material sheet 12 contains an ethylene·α-olefin copolymer is preferable.

An embodiment in which the first encapsulating material sheet 11 contains an ethylene-vinyl acetate copolymer, the second encapsulating material sheet 12 contains an ethylene·α-olefin copolymer, and the above-described MFR ratio is smaller than 1.0 is particularly preferable.

An embodiment in which the first encapsulating material sheet 11 contains an ethylene·α-olefin copolymer, the second encapsulating material sheet 12 contains an ethylene-vinyl acetate copolymer, the above-described MFR ratio is smaller than 1.0, and the MFR of the ethylene·α-olefin copolymer constituting the first encapsulating material sheet 11 is equal to or smaller than 10 g/10 min, and further equal to or smaller than 8 g/10 min is particularly preferable.

(Silane coupling agent)

The first and second encapsulating material sheets may contain a silane coupling agent. Containing the silane coupling agent allows adhesion strength between the first and second encapsulating material sheets, and other members to be excellent. The content of the silane coupling agent in the first and second encapsulating material sheets is preferably 0.1 parts by mass to 2 parts by mass, more preferably 0.1 parts by mass to 1.8 parts by mass, and particularly preferably 0.1 parts by mass to 1.5 parts by mass, with respect to 100 parts by mass of the cross-linkable resin. When the content of the silane coupling agent is in the above range, it is possible to improve adhesiveness of the first and second encapsulating material sheets, and to more reliably suppress generation of bubbles in the first and second encapsulating material sheets.

As the silane coupling agent, for example, one or two or more types selected from the following materials may be used: vinyltriethoxy silane, vinyltrimethoxy silane, vinyl tris($\beta$-methoxyethoxy silane), 2-(3,4-epoxycyclohexyl)ethyl trimethoxy silane, 3-glycidoxypropyl methyl dimethoxy silane, 3-glycidoxypropyl trimethoxy silane, 3-glycidoxypropyl methyl ditriethoxy silane, 3-glycidoxypropyl triethoxy silane, p-styryl trimethoxy silane, 3-aminopropyl triethoxy silane, 3-aminopropyl trimethoxy silane, N-2- (aminoethyl) -3-aminopropyl methyl dimethoxy silane, N-2-(aminoethyl)-3-aminopropyl trimethoxy silane, 3-triethoxysilyl-N-(1,3-dimethyl-butylidene)propylamine, N-phenyl-3-aminopropyl trimethoxy silane, 3-ureidopropyl triethoxy silane, 3-isocyanate propyl triethoxy silane, 3-methacryloxypropyl trimethoxy silane, 3-methacryloxypropyl methyl dimethoxy silane 3-methacryloxypropyl triethoxy silane, 3-methacryloxypropyl methyl diethoxy silane, and 3-acryloxy propyl trimethoxy silane.

From a viewpoint of improvement of adhesiveness, among these materials, one or two or more types selected from the following materials are preferably used: 3-glycidoxypropyl trimethoxy silane, 3-glycidoxypropyl triethoxy silane, 3-aminopropyl triethoxy silane, 3-methacryloxypropyl trimethoxy silane, 3-methacryloxypropyl triethoxy silane, 3-acryloxy propyl trimethoxy silane, and vinyl triethoxy silane.

(Organic peroxide)

The first and second encapsulating material sheets preferably contain organic peroxide. Such organic peroxide preferably has an one minute half-life temperature which is 100°C to 170°C, based on balance between productivity in extrusion sheet molding, and a cross-linking rate when laminate molding is performed for a solar cell module. When the one minute half-life temperature of the organic peroxide is equal to or higher than 100°C, it is possible to easily perform sheet molding, and to cause an appearance of the first and second encapsulating material sheets to be good. It is possible to prevent lowering of a dielectric breakdown voltage, to prevent deterioration of moisture permeability, and to improve adhesiveness. When the one minute half-life temperature of the organic peroxide is equal to or lower than 170°C, it is possible to suppress a decrease of the cross-linking rate when the laminate molding is performed for a solar cell module, and to prevent deterioration of productivity of the solar cell module. In addition, it is possible to prevent deterioration of the thermal resistance and the adhesiveness of the first and second encapsulating material sheets.

As organic peroxide of which the one minute half-life temperature is in a range of 100°C to 170°C, one or two types or more selected from the following materials may be used: dilauroyl peroxide, 1,1,3,3-tetramethylbutyl peroxy-2-ethylhexanoate, dibenzoyl peroxide, t-amyl peroxy-2-ethylhexanoate, t-butyl peroxy-2-ethylhexanoate, t-butyl peroxy isobutyrate, t-butyl peroxy maleic acid, 1,1-di(t-amyl peroxy)-3,3,5-trimethylcyclohexane, 1,1-di(t-amyl peroxy)cyclohexane, t-amyl peroxy isononanoate, t-amyl peroxy normal octoate, 1,1-di(t-butyl peroxy)-3,3,5-trimethylcyclohexane, 1,1-di(t-butyl peroxy) cyclohexane, t-butyl peroxy isopropyl carbonate, t-butyl peroxy-2-ethylhexyl carbonate, 2,5-dimethyl-2,5-di (benzoyl peroxy) hexane, t-amyl-peroxy benzoate, t-butyl peroxy acetate, t-butyl peroxy isononanoate, 2,2-di(t-butyl peroxy)butane, and t-butyl peroxy benzoate.

Among these materials, one or two types or more selected from the following materials is preferably used: dilauroyl peroxide, t-butyl peroxy isopropyl carbonate, t-butyl peroxy acetate, t-butyl peroxy isononanoate, t-butyl peroxy-2-ethylhexyl carbonate, and t-butyl peroxy benzoate.

Since the first and second encapsulating material sheets contain organic peroxide, and thus have excellent cross-linking characteristics, it is possible to complete the manufacturing process at a high temperature for a short term without a need for performing of an adhesion process having two stages in a vacuum laminator and a cross-linking furnace.

The content of organic peroxide in the first and second encapsulating material sheets is preferably 0.1 parts by mass to 1.2 parts by mass, more preferably 0.2 parts by mass to 1.0 part by mass, and further preferably 0.2 parts by mass to 0.8 parts by mass, with respect to 100 parts by mass of the cross-linkable resin. When the content of organic peroxide is equal to or greater than the lower limit value, deterioration of the cross-linking characteristics of the first and second encapsulating material sheets is suppressed and a grafting reaction of the silane coupling agent on a main chain of the cross-linkable resin is performed well. Thus, it is possible to suppress deterioration of the thermal resistance and the adhesiveness. When the content of organic peroxide is equal to or smaller than the upper limit value, it is possible to further decrease the generated amount of a decomposition product of organic peroxide, and to more reliably suppress generation of bubbles in the first and second encapsulating material sheets.

(Ultraviolet absorbing agent, light stabilizer, and heat-resistance stabilizer)

The first and second encapsulating material sheets preferably contain at least one additive selected from a group including a ultraviolet absorbing agent, a light stabilizer, and a heat-resistance stabilizer, more preferably contain at least two additives, and further preferably contain all of the three additives.

The content of the three additives in the first and second encapsulating material sheets is preferably 0.005 parts by mass to 5 parts by mass, with respect to 100 parts by mass of the cross-linkable resin. When the content of the three additives is in the above range, it is possible to sufficiently ensure an effect of improving resistance for the constant temperature and humidity, resistance against a heat cycle, weather-resistance stability, and heat-resistance stability. In addition, it is possible to prevent deterioration of the transparency or the adhesiveness of the first and second encapsulating material sheets.

As the ultraviolet absorbing agent, for example, one or two types or more selected from the following materials may be used: a benzophenone-based ultraviolet absorbing agent such as 2-hydroxy-4-normal-octyloxy benzophenone, 2-hydroxy-4-methoxy benzophenone, 2,2-dihydroxy-4-methoxy benzophenone, 2-hydroxy-4-methoxy-4-carboxy benzophenone, and 2-hydroxy-4-N-octoxy benzophenone; a benzotriazole-based ultraviolet absorbing agent such as 2-(2-hydroxy-3,5-di-t-butyl phenyl)benzotriazole and 2-(2-hydroxy-5-methyl phenyl)benzotriazole; and a salicylic acid ester-based ultraviolet absorbing agent such as phenyl salicylate and p-octyl phenyl salicylate.

As the light stabilizer, for example, one or two types or more selected from the following compounds may be used: hindered amine compounds and hindered piperidine-based compounds such as bis(2,2,6,6-tetramethyl-4-piperidyl)sebacate, and poly[{6-(1,1,3,3-tetramethyl butyl)amino-1,3,5-triazine-2,4-diyl} {(2,2,6,6-tetramethyl-4-piperidyl)imino}hexamethylene {(2,2,6,6-tetramethyl-4-piperidyl)imino}].

As the heat-resistance stabilizer, for example, one or two types or more selected from the following materials may be used: a phosphite-based heat-resistance stabilizer such as tris(2,4-di-tert-butylphenyl)phosphite, bis[2,4-bis(1,1-dimethylethyl)-6-methylphenyl]ethyl ester phosphite, tetrakis(2,4-di-tert-butylphenyl) [1,1-biphenyl]-4,4'-diyl bis phosphonites, and bis(2,4-di-tert-butylphenyl)pentaerythritol diphosphite; a lactone-based heat-resistance stabilizer such as a reaction product between 3-hydroxy-5,7-di-tert-butyl-furan-2-one and o-xylene; a hindered phenol-based heat-resistance stabilizer such as 3,3',3'',5,5',5''-hexa-tert-butyl-a,a',a''-(methylene-2,4,6-triyl)t ri-p-cresol, 1,3,5-trimethyl-2,4,6-tris(3,5-di-tert-butyl-4-hydroxyphenyl)ben zylbenzene, pentaerythritol tetrakis[3-(3,5-di-tert-butyl-4-hydroxyphenyl)propionate], octadecyl-3-(3,5-di-tert-butyl-4-hydroxyphenyl)propionate, and thiodiethylene bis[3-(3,5-di-tert-butyl-4-hydroxyphenyl)propionate]; a sulfur-based heat-resistance stabilizer; and an amine-based heat-resistance stabilizer. Among these materials, the phosphite-based heat-resistance stabilizer and the hindered phenol-based heat-resistance stabilizer are preferable.

(Crosslinking aid)

The first and second encapsulating material sheets preferably contain a crosslinking aid. The content of the crosslinking aid in the first and second encapsulating material sheets is preferably 0. 05 parts by mass to 5 parts by mass, with respect to 100 parts by mass of the cross-linkable resin. Thus, it is possible to cause the first and second encapsulating material sheets to have an appropriate cross-linked structure, and to improve the thermal resistance, the mechanical characteristics, and the adhesiveness of the first and second encapsulating material sheets.

As the crosslinking aid, a compound having two or more double bonds in a molecule may be used. For example, one or two types or more selected from the following compounds may be used: monoacrylate such as t-butyl acrylate, lauryl acrylate, cetyl acrylate, stearyl acrylate, 2-methoxyethyl acrylate, ethyl carbitol acrylate, and methoxy tripropylene glycol acrylate; monomethacrylate such as t-butyl methacrylate, lauryl methacrylate, cetyl methacrylate, stearyl methacrylate, methoxyethylene glycol methacrylate, methoxypolyethylene glycol methacrylate; diacrylate such as 1,4-butanediol diacrylate, 1,6-hexanediol diacrylate, 1,9-nonanediol diacrylate, neopentyl glycol diacrylate, diethylene glycol diacrylate, tetraethylene glycol diacrylate, polyethylene glycol diacrylate, tripropylene glycol diacrylate, and polypropylene glycol diacrylate; dimethacrylate such as 1,3-butanediol dimethacrylate, 1,6-hexanediol dimethacrylate, 1,9-nonanediol dimethacrylate, neopentyl glycol dimethacrylate, ethylene glycol dimethacrylate, diethylene glycol dimethacrylate, triethylene glycol dimethacrylate, and polyethylene glycol dimethacrylate; triacrylate such as trimethylol propane triacrylate, tetramethylol methane triacrylate, and pentaerythritol triacrylate; trimethacrylate such as trimethylol propane trimethacrylate, and trimethylol ethane trimethacrylate; tetraacrylate such as pentaerythritol tetraacrylate and tetramethylol methane tetraacrylate; divinyl aromatic compounds such as divinylbenzene and di-i-propenyl benzene; cyanurate such as triallyl cyanurate and triallyl isocyanurate; diallyl compounds such as diallyl phthalate; triallyl compounds; oxime such as p-quinone dioxime and p-p'-dibenzoyl quinone dioxime; and maleimide such as phenyl maleimide.

Among these crosslinking aids, one or two types or more selected from the following compounds is preferably used: diacrylate; dimethacrylate; divinyl aromatic compound; triacrylate such as trimethylol propane triacrylate, tetramethylol methane triacrylate, and pentaerythritol triacrylate; trimethacrylate such as trimethylolpropane trimethacrylate and trimethylolethane trimethacrylate; tetraacrylate such as pentaerythritol tetraacrylate and tetramethylolmethane tetraacrylate; cyanurate such as triallyl cyanurate and triallyl isocyanurate; diallyl compounds such as diallyl phthalate; triallyl compounds; oxime such as p-quinone dioxime and p-p'-dibenzoyl quinone dioxime; and maleimide such as phenyl maleimide. Further, among these materials, triallyl isocyanurate is particularly preferable from a point of enabling more suppression of occurrence of bubbles in the first and second encapsulating material sheets and a point of excellent cross-linking characteristics.

(Other additive)

The first and second encapsulating material sheets may appropriately contain various components other than the above-described components, in a range without departing from the purpose of the present invention. For example, the first and second encapsulating material sheets may appropriately contain various types of polyolefin, stylene-based block copolymers, ethylene-based block copolymers, and propylene-based polymer, and the like, except for the cross-linkable resin. These materials may be contained so as to be 0.0001 parts by mass to 50 parts by mass, and to preferably be 0.001 parts by mass to 40 parts by mass, with respect to 100 parts by mass of the cross-linkable resin. In addition, one or more additives selected from the various resins except for polyolefin, and/or various rubbers, plasticizers, fillers, pigments, dyes, antistatic agents, antibacterial agents, antifungal agents, flame retardants, dispersants, and the like may be appropriately contained.

The thickness of the first and second encapsulating material sheets after the cross-linking treatment is preferably 0.01 mm to 2 mm, more preferably 0.05 mm to 1.5 mm, further preferably 0.1 mm to 1.2 mm, further more preferably 0.2 mm to 1 mm, and particularly preferably 0.3 mm to 0.9 mm. Among these ranges, a range of 0.3 mm to 0.8 mm is preferable. When the thickness is in the above range, it is possible to suppress occurrence of damage of the light-receiving surface side protective member, the solar cell element, a thin-film electrode in the laminate process, and to obtain high photovoltaic amount by ensuring sufficient light transmittance. In addition, it is preferable that laminate molding can be performed for a solar cell module at a low temperature.

(Manufacturing method of first and second encapsulating material sheets)

A method which is generally used may be used as a manufacturing method of the first and second encapsulating material sheets. However, a method in which molten blending is performed by using a calender roll, a kneader, a Banbury mixer, an extruder, and the like, and thereby manufacturing is performed is preferable. Particularly, manufacturing by using an extruder which enables continuous production is preferable.

A molding method of the first and second encapsulating material sheets is not particularly limited. However, various well-known molding methods (cast molding, extrusion sheet molding, inflation molding, injection molding, compression molding, and the like) may be employed. Particularly, the following method is preferable from a point of enabling improvement of the adhesiveness of the first and second encapsulating material sheets, and enabling improvement of long-term reliability for the weather resistance, the thermal resistance, or the like by preventing deterioration of the additives. Firstly, a cross-linkable resin, and various additives such as a silane coupling agent, organic peroxide, an ultraviolet absorbing agent, a light stabilizer, a heat-resistance stabilizer, a crosslinking aid, and other additives are blended with each other in the polyethylene bag or are mixed with each other by a stirring and mixing machine such as a Henschel mixer, a tumbler mixer, and a Super mixer. Then, a composition obtained by blending or mixing is put into a hopper for extrusion sheet molding. While molten kneading is performed, extrusion sheet molding is performed, and thus the first and second encapsulating material sheets are obtained.

The extrusion temperature range is preferably 100°C to 130°C. It is possible to improve productivity of the first and second encapsulating material sheets and to obtain the first and second encapsulating material sheets which have a good appearance and excellent adhesiveness, by being in this range.

As an example of the manufacturing method of the first and second encapsulating material sheets, a method in which the cross-linkable resin is mixed with an additive such as organic peroxide by using a Henschel mixer or a tumbler mixer, the obtained mixture is supplied to an extruder, and molding is performed so as to have a sheet shape is exemplified. Each of the cross-linkable resin and the additives may be supplied to the extruder, and the cross-linkable resin and the additives may be molten and mixed in the extruder. The cross-linkable resin may be molten and kneaded once so as to create a mixed pellet, and the mixed pellet may be supplied to the extruder again so as to perform molding to be a sheet.

Embossing may be performed on surfaces of the first and second encapsulating material sheets. Embossing may be performed on a single side of each of the first and second encapsulating material sheets or may be performed on both sides thereof. A sheet surface of each of the first and second encapsulating material sheets is decorated by embossing, and thus blocking between the first and second encapsulating material sheets or blocking between the first and second encapsulating material sheets and another sheet is prevented. Because embossing causes the storage elastic moduli of the first and second encapsulating material sheets to be reduced, the embossing cushions the solar cell element and the like when the first and second encapsulating material sheets and a solar cell element are laminated. Thus, it is possible to prevent damage of the solar cell element.

Porosity P (%) is indicated by a percentage $V_H/V_A \times 100$ of the total volume $V_H$ of concave portions of the first and second encapsulating material sheets per a unit area, and the apparent volume $V_A$ of the first and second encapsulating material sheets. The porosity P (%) is preferably 10% to 50%, more preferably 10% to 40%, and further preferably 15% to 40%. The apparent volume $V_A$ of the first and second encapsulating material sheets is obtained by multiplying the maximum thickness of the first and second encapsulating material sheets by the unit area.

When the porosity P is equal to or greater than 10%, it is possible to sufficiently reduce the elastic moduli of the first and second encapsulating material sheets. Thus, it is possible to obtain sufficient cushioning properties. Accordingly, it is possible to prevent the occurrence of cracks in the solar cell element, for example, even though large pressure is locally applied to the solar cell element when laminating is performed. When the porosity P is equal to or smaller than 80%, it is possible to perform de-airing well when pressing is performed during laminating. Thus, it is possible to prevent deterioration of the appearance of a solar cell module and to prevent corrosion of the electrode. In addition, it is possible to obtain sufficient adhesion strength by increasing a contact area of the first and second encapsulating material sheets and an adherend.

The porosity P may be obtained by the following calculation. The apparent volume $V_A$ (mm$^3$) of the first and second encapsulating material sheets which are subjected to embossing is calculated by using the following Expression (A) and by using the product of the maximum thickness $t_{max}$ (mm) of the first and second encapsulating material sheets and the unit area (for example, 1 m$^2$=1000×1000=10$^6$ mm$^2$).

$$V_A \ (mm^3) = t_{max} \ (mm) \times 10^6 \ (mm^2) \quad (A)$$

The actual volume $V_0$ (mm$^3$) of the first and second encapsulating material sheets in the unit area is calculated by applying the specific weight ρ (g/mm$^3$) of a resin constituting the first and second encapsulating material sheets, and the actual weights W(g) of the first and second encapsulating material sheets per the unit area (1 m$^2$) to the following Expression (B).

$$V_0 \ (mm^3) = W/\rho \quad (B)$$

The total volume $V_H$ (mm$^3$) of the concave portions of the first and second encapsulating material sheets per the unit area is calculated by subtracting "the actual volume $V_0$" from "the apparent volume $V_A$ of the first and second encapsulating material sheets", as indicated by the following Expression (C).

$$V_H \ (mm^3) = V_A - V_0 = V_A - (W/\rho) \quad (C)$$

Accordingly, the porosity P (%) may be obtained as follows.

$$\text{Porosity } P(\%) = V_H/V_A \times 100$$
$$= (V_A - (W/\rho))/V_A \times 100$$
$$= 1 - W/(\rho \cdot V_A) \times 100$$
$$= 1 - W/(\rho \cdot t_{max} \cdot 10^6) \times 100$$

The porosity P (%) may be obtained by using the calculation expressions. However, the porosity P (%) may be obtained in such a manner that a section of the actual first and second encapsulating material sheets or a surface subjected to the embossing is captured by using a microscope, and image processing and the like is performed on the obtained image.

In order to reduce stress applied to the solar cell element or the wiring material by the first and second encapsulating material sheets when a solar cell module is manufactured, the storage elastic modulus of the first encapsulating material sheet and the second encapsulating material sheet which are not subjected to the cross-linking treatment is important under a temperature environment of 90°C to 160°C, particularly, under a temperature environment of 120°C which causes the resin to become flexible. Thus, satisfying the above-described Expression (1) is important.

In order to provide a solar cell module which further suppresses the occurrence of cracks of a solar cell element and breaking of the wiring material, and causes reception an influence of a temperature cycle to be further difficult, it is important to cause the relationship between the following factors to satisfy the above-described Expression (2): the storage elastic modulus of the first encapsulating material subjected to the cross-linking treatment in a temperature range of -40°C to 90°C which is used as a general temperature cycle test condition, the linear expansion coefficient on a low temperature side of -40°C to 0°C, and the linear expansion coefficient at 50°C to 90°C.

As described above, the storage elastic moduli of the first and second encapsulating material sheets before the cross-linking treatment, the storage elastic modulus of the first encapsulating material sheet after the cross-linking treatment, and the linear expansion coefficient thereof are applied to material design. Thus, it is possible to provide a solar cell module which suppresses stress applied to the solar cell element or the wiring material when the solar cell module is manufactured, further suppresses the occurrence of cracks in the solar cell element or breaking of the wiring material, and causes reception of an influence of the temperature cycle to be difficult.

The first encapsulating material sheet 11 may be configured by a plurality of encapsulating material sheets. In this case, regarding the storage elastic modulus ($P_1$) of the first encapsulating material sheet 11 before the cross-linking treatment, the storage elastic modulus ($G_1$) of the first encapsulating material sheet 11 after the cross-linking treatment, the linear expansion coefficient ($\alpha_1$), and the linear expansion coefficient ($\alpha_2$), the value of Expression (1) and the value of Expression (2) may be obtained by using a measured value and a sheet thickness of each of sheets constituting the first encapsulating material sheet 11. For example, in a case where the first encapsulating material sheet is configured by n layers of a sheet $P_{1i}$ (i=1 to n), and an average thickness of the layers (value obtained by standardizing the thickness of all of the layers to be 1) is set as Di, a relationship with Expression (1) configured from the storage elastic modulus ($P_1$) before the cross-linking treatment and the storage elastic modulus ($P_2$) of the second encapsulating material sheet before the cross-linking treatment may be represented as in the following Expression (3).

$$\mathrm{Log}\left(\frac{\sum_{i=1}^{n}(Di \times P_{1i})}{P_2}\right) \quad \cdots\cdots (3)$$

<Solar cell module>

FIG. 1 schematically illustrates the embodiment of the solar cell module 10 according to the present invention.

The solar cell module 10 according to the embodiment is obtained by using the above-described sheet set for encapsulating a solar cell according to the embodiment. The solar cell module 10 includes a solar cell element 16, a pair of a first encapsulating material sheet 11 on a light-receiving surface side and a second encapsulating material sheet 12 on a back surface side, a light-receiving surface side protective member 14, and a back surface side protective member (back sheet) 13, for example. The solar cell element 16 is formed of polycrystalline silicon and the like. The pair of the first encapsulating material sheet 11 and the second encapsulating material sheet 12 causes the solar cell element 16 to be interposed therebetween, and be encapsulated.

That is, the solar cell module 10 according to the embodiment is configured by a solar cell module protection sheet (light-receiving surface side protective member 14)/the first encapsulating material sheet 11/the solar cell element 16/the second encapsulating material sheet 12/a solar cell module protection sheet (back surface side protective member 13). However, the solar cell module 10 according to the embodiment is not limited to the described configuration. Some of the above layers may be appropriately omitted, or a layer other than the above layers may be appropriately provided, in a range without departing from the purpose of the present invention. As the layer other than the above layer, for example, an adhesive layer, an impact absorptive layer, a coating layer, an anti-reflection layer, a back side re-reflection layer, a light diffusion layer, and the like may be exemplified. These layers are not particularly limited. However, considering the purpose for providing each of the layers or the characteristics of each of the layers, the layers may be respectively provided at proper positions. In the solar cell module 10 according to the embodiment, an interconnector (wiring material 15) which links a plurality of solar cell elements 16 to each other may be on the first encapsulating material sheet 11 side or be on the second encapsulating material sheet 12 side. The interconnector may be provided over both of the encapsulating materials.

A layer formed by the sheet set for encapsulating a solar cell according to the embodiment is also referred to as an encapsulating layer. A layer obtained by cross-linking of the first encapsulating material sheet 11 is also referred to as a first encapsulating layer. A layer obtained by cross-linking of the second encapsulating material sheet 12 is also referred to as a second encapsulating layer.

(Solar cell element)

As the solar cell element 16, various solar cell elements may be used. The various solar cell elements may be formed of silicons such as single-crystalline silicon, polycrystalline silicon, and amorphous silicon, semiconductors of III-V group compounds or II-VI group compounds such as gallium-arsenic, copper-indium-selenium, and cadmium-tellurium.

In the solar cell module 10, plural solar cell elements 16 are electrically connected to each other in series through the wiring material 15. The wiring material 15 includes a conductive line and a solder joint portion.

(Light-receiving surface side protective member)

Examples of the light-receiving surface side protective member 14 include a glass plate; and a resin plate formed by an acrylic resin, polycarbonate, polyester, and a fluorine-containing resin.

(Back surface side protective member)

As the back surface side protective member 13, a singleton or a multilayer sheet of metals or various thermoplastic resin films and the like is exemplified. For example, metal such as tin, aluminum, and stainless steel; an inorganic material such as glass; the various thermoplastic resin films formed of polyester, inorganic vapor deposition polyester, a fluorine-containing resin, and polyolefin; and the like are exemplified.

The back surface side protective member 13 may be a single layer or a multilayer.

Here, in a case where a glass plate is used as the light-receiving surface side protective member 14, and a thermoplastic resin film is used as the back surface side protective member 13, bending, fatigue, or breaking of the wiring material in the solar cell module easily occur. Thus, in a case where the glass plate is used as the light-receiving surface side protective member 14, and the thermoplastic resin film is used as the back surface side protective member 13, it is particularly effective that the sheet set for encapsulating a solar cell according to the embodiment be used as the encapsulating layer.

(Wiring material)

The wiring material 15 generally corresponds to an interconnector which links a plurality of solar cell elements to each other.

As the wiring material 15, a metal foil such as an aluminium foil and a copper foil is exemplified.

<Manufacturing method of solar cell module>

A manufacturing method of the solar cell module 10 according to the embodiment is not particularly limited. However, for example, the following method is exemplified.

Firstly, the plurality of solar cell elements 16 which are electrically connected to each other by using the wiring material 15 are interposed between the first encapsulating material sheet 11 and the second encapsulating material sheet 12. The first encapsulating material sheet 11 and the second encapsulating material sheet 12 are interposed between the light-receiving surface side protective member 14 and the back surface side protective member 13, and thereby a stacked body is manufactured. Then, the stacked body is heated, and thus the first encapsulating material sheet 11 and the second encapsulating material sheet 12 are caused to adhere to each other, the first encapsulating material sheet 11 and the light-receiving surface side protective member 14 are caused to adhere to each other, and the second encapsulating material sheet 12 and the back surface side protective member 13 are caused to adhere to each other.

As conditions when the stacked body is heated, heating may be constantly performed at the one minute half-life temperature of organic peroxide, for 5 minutes to 10 minutes. For example, when the one minute half-life temperature of organic peroxide is 160°C, the stacked body may be constantly heated at 160°C for 5 minutes to 10 minutes.

Hitherto, the embodiment according to the present invention is described with reference to the drawings. However, the above-described embodiment is only an example of the present invention, and various configurations other

17

than the above embodiment may be employed.

EXAMPLE

The present invention will be specifically described below based on examples. However, the present invention is not limited to the following examples.

(1) Measuring method of physical properties

[Content ratio of ethylene unit and $\alpha$-olefin unit in ethylene·$\alpha$-olefin copolymer]

0.35 g of a sample were heated and dissolved in 2.0 ml of hexachlorobutadiene, and thereby a solution was obtained. The obtained solution is filtered by a glass filter (G2). Then, 0.5 ml of deuterated benzene was added to the resultant of filtering. The resultant of addition was put into a NMR tube having an inner diameter of 10 mm. $^{13}$C-NMR was performed at 120°C by using JNM GX-400 type NMR measuring device (manufactured by Jeol Ltd.). The accumulated number of times of measuring was equal to or greater than 8000 times. The content ratio of the ethylene unit, and the content ratio of the $\alpha$-olefin unit in a copolymer were determined by using the obtained $^{13}$C-NMR spectrum.

[MFR]

The MFR of the ethylene·$\alpha$-olefin copolymer and the ethylene-vinyl acetate copolymer, which was measured under conditions of a temperature of 190°C, and a load of 2.16 kg, based on ASTM D1238.

[Density]

The density of the ethylene·$\alpha$-olefin copolymer was measured based on ASTM D1505.

[Storage elastic modulus]

Measuring was performed on a sample of the encapsulating material sheet at a temperature of 25°C (room temperature) to 180°C, at a frequency of 1.0 Hz, at a temperature rising rate of 10°C/minute in a shear mode by using a solid viscoelasticity device (ReoStress, product manufactured by HAAKE Corporation). A disportable parallel plate of 20 mm$\varphi$ was used as a plate, and strain control was performed at 0.01. Thus, the storage elastic modulus (P) of the encapsulating material sheet at 120°C before the cross-linking treatment, and the storage elastic modulus (G1) of the encapsulating material sheet at 90°C after the cross-linking treatment were calculated.
Here, the cross-linking treatment for the encapsulating material sheet was performed by using a laminate device (manufactured by NPC Corporation, LM-110X160S), after the encapsulating material sheet was cut so as to have a size of 10 cm×10 cm, and the cross-linking treatment was performed at 150°C at vacuum pressure of 250 Pa for 3 minutes, and at pressing pressure of 100 kPa for 15 minutes.

[Linear expansion coefficient]

The linear expansion coefficient of the encapsulating material sheet after the cross-linking treatment was measured under conditions of a nitrogen atmosphere, a temperature rising rate of 5°C/minute, a test load of 3 gf, a temperature range of -40°C to 90°C, and a film extension mode, by using a thermomechanical analyzer TMA-SS6100 (manufactured by SSI Nano technologies Inc.). Thus, the linear expansion coefficient of the encapsulating material sheet at a temperature of -40°C to 0°C after the cross-linking treatment, and the linear expansion coefficient of the encapsulating material sheet at a temperature of 50°C to 90°C after the cross-linking treatment were calculated.
Here, the cross-linking treatment for the encapsulating material sheet was performed by using a laminate device (manufactured by NPC Corporation, LM-110X160S), after the encapsulating material sheet was cut so as to have a size of 10 cm×10 cm, and the cross-linking treatment was performed at 150°C at vacuum pressure of 250 Pa for 3 minutes, and at pressing pressure of 100 kPa for 15 minutes.

[Evaluation of bent amount]

FIG. 2 is a schematic cross-sectional view illustrating the stacked body 20 used in evaluation of the bent amount.
As glass 22, a blue plate glass which was cut out so as to be 12 cm×7.5 cm, has a thickness of 3.2 mm, and was manufactured by AGC fabritech Co., Ltd was used.

As an element for evaluation bending, an element manufactured in such a manner that an aluminium plate (3 cm×2 cm) 23 having a thickness of 0.3 mm was provided on a PET film 24 which was cut out so as to be 4.2 cm×3 cm, and has a thickness of 0.1 mm, at a gap of 2 mm, and the two pieces was bonded to each other was used.

The first encapsulating material sheet 11 and the second encapsulating material sheet 12 were disposed on the glass 22 so as to cause an element for evaluating the bending to be interposed therebetween. A PET film 21 of 0.25 mm, which was cut out so as to be 13 cm×8 cm was stacked as a back sheet (back surface side protective member), on an upper surface of the second encapsulating material sheet 12. The obtained stacked body 20 was laminated in a state where the glass 22 side was set to be downward, by using a vacuum laminator (product manufactured by NPC Corporation: LM-110x160-S), and the laminating was performed at a heating plate temperature of 150°C for 3 minutes of a vacuum period and for 15 minutes of a pressing period. Then, the first encapsulating material sheet 11, the second encapsulating material sheet 12, and the PET film 21 extruded from the glass 22 were cut off.

The stacked body 20 was taken along a cross-section in which bending of the PET film 24 of 2 mm, which was disposed between aluminium plates 23 could be confirmed. The bent amount of the PET film 24 was measured by using a microscope. The maximum value of the bent amount when the PET film 24 was pushed between the aluminium plates 23 was measured by using a planar surface of the aluminium plate 23 as a reference.

A: Bent amount ≤ 0.160 mm
B: 0.160 mm < bent amount ≤ 0.165 mm
C: Bent amount > 0.165 mm

[Temperature cycle test]

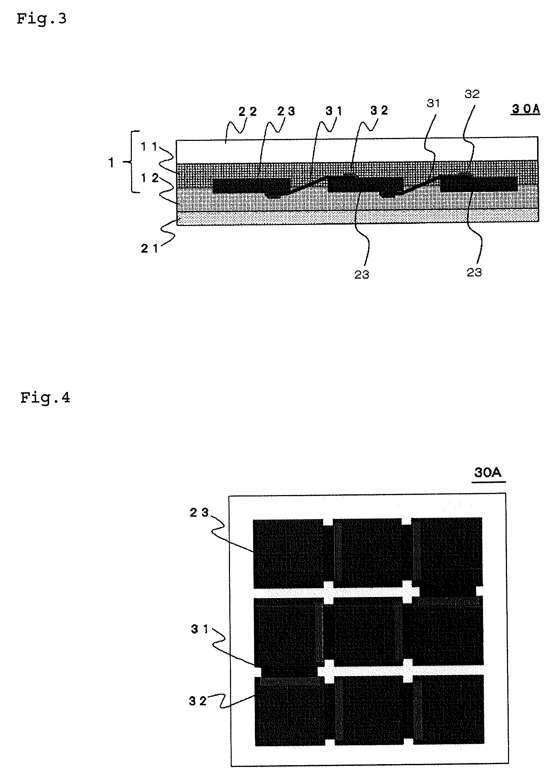

FIG. 3 is a schematic cross-sectional view illustrating a pseudo module 30A used in a temperature cycle test in examples and comparative examples. FIG. 4 is a schematic front view illustrating the pseudo module 30A used in the temperature cycle test in the examples and the comparative examples.

AS the glass 22, a blue plate glass which was cut out so as to be 20 cmx20 cm, has a thickness of 3.2 mm, and was manufactured by AGC fabritech Co., Ltd was used.

As an element for evaluation, an element in which aluminium plates (4 cmx4 cm) 23 having a thickness of 0.3 mm were arranged in 4×4 at an interval of 2 mm, and aluminium foils 31 having a thickness of 0.05 mm and a size of 1 cm×3 cm were fixed on a Kapton tape 32 between the aluminium plates 23 was used.

The first encapsulating material sheet 11 and the second encapsulating material sheet 12 were disposed on the glass 22 so as to cause the element for evaluation to be interposed therebetween. The PET film 21 was stacked as the back sheet (back surface side protective member) on an upper surface of the second encapsulating material sheet 12.

The obtained stacked body 30A was laminated in a state where the glass 22 side was set to be downward, by using a vacuum laminator (product manufactured by NPC Corporation: LM-110x160-S), and the laminating was performed at a heating plate temperature of 150°C for 3 minutes of a vacuum period and for 15 minutes of a pressing period.

The obtained pseudo module was put into a temperature cycle test tank by setting one hour at -40°C, two hours for heating, and one hour at 90°C as one cycle. The cycle was performed 2000 times. Then, the appearance of the pseudo module after 2000 cycles was observed.

A: there is no change in appearance
B: a slight change in appearance is confirmed (deformation of the aluminium foil 31 and the like)
C: a change in appearance is present (significant deformation or breaking of the aluminium foil 31)

Being unmeasurable: maintaining of a shape is difficult due to occurrence of melting and the like of the encapsulating material sheet

(2) Cross-linkable resin

(2-1) Ethylene-vinyl acetate copolymer (EVA)

As an ethylene-vinyl acetate copolymer (EVA) used in the examples and the comparative examples, an ethylene-vinyl acetate copolymer containing vinyl acetate so as to be 27 mass% and having a MFR of 16.8 g/10 minutes was used.

(2-2) Synthesis of ethylene·α-olefin copolymer

(Synthesis example 1)

A toluene solution of methylaluminoxane as a cocatalyst was supplied to one supply port of a continuous polymerization reactor which included a stirring blade and has an inner volume of 50 L, at 8.0 mmol/hr. A hexane slurry of bis(1,3-dimethyl-cyclopentadienyl)zirconium dichloride as a main catalyst was supplied to the one supply port at 0.025 mmol/hr. A hexane solution of triisobutyl aluminum was supplied to the one supply port at a rate of 0.5 mmol/hr. Normal hexane which was dehydrated and refined was continuously supplied so as to cause the total amount of normal hexane to be 20 L/hr which was used as a catalyst solution and a polymerization solution, and was dehydrated and refined. At the same time, ethylene was continuously supplied to the other supply port of the polymerization reactor at a rate of 3 kg/hr, 1-butene was continuously supplied to the other supply port at a rate of 15 kg/hr, and hydrogen was continuously supplied to the other supply port at a rate of 5 NL/hr. Continuous solution polymerization was performed under conditions of a polymerization temperature of 90°C, the entire pressure of 3 MPaG, and residence time of 1.0 hour. A normal hexane/toluene mixed solution of an ethylene·α-olefin copolymer, which was generated in the polymerization reactor was continuously discharged through an exhaust port provided at the bottom portion of the polymerization reactor and was guided to a linking pipe of which a jacket portion was heated with steam of 3 kg/cm$^2$ to 25 kg/cm$^2$ such that the normal hexane/toluene mixed solution of the ethylene·α-olefin copolymer was in a range of 150°C to 190°C. In just before the linking pipe, a supply port into which methanol functioning as a catalyst inactivator was injected was attached to the polymerization reactor. Methanol was injected at a rate of about 0.75 L/hr, and the injected methanol was joined to the normal hexane/toluene mixed solution of the ethylene·α-olefin copolymer. The normal hexane/toluene mixed solution of the ethylene·α-olefin copolymer, which was held at about 190°C in a linking pipe having an attached steam jacket was continuously delivered to a flash tank, so as to hold about 4.3 MPaG. The delivery was performed by adjusting an opening of a pressure control valve which was provided at a termination portion of the linking pipe. In transfer into the flash tank, the temperature of the solution and the opening of a pressure regulating valve were set so as to hold pressure in the flash tank to be about 0.1 MPaG, and to hold the temperature of a steam portion in the flash tank to be about 180°C. Then, strands were cooled in a water tank through a single-axis extruder in which the temperature of a dice was set to be 180°C. The strands were cut out by a pellet cutter, and thereby an ethylene·α-olefin copolymer was obtained as a pellet. A yield quantity was 2.2 kg/hr. Physical properties are shown in Table 1.

(Synthesis examples 2 to 3)

A supplied amount of the raw materials et al was adjusted based on the conditions of Synthesis example 1, and thus an ethylene·α-olefin copolymer shown in Table 1 was obtained.

[Table 1]

|  | Synthesis example 1 | Synthesis example 2 | Synthesis example 3 |
|---|---|---|---|
| Type of α-olefin | 1-butene | 1-butene | 1-butene |
| Content of α-olefin unit [mol%] | 14 | 13 | 13 |
| Content of ethylene unit [mol%] | 86 | 87 | 87 |
| Density [g/cm$^3$] | 0.870 | 0.873 | 0.873 |
| MFR [g/10 minutes] | 20 | 4.5 | 2.2 |

(3) Manufacturing of encapsulating material sheet

(Manufacturing example 1)

0.5 parts by mass of 3-methacryloxypropyl trimethoxy silane as the silane coupling agent, and 1.0 parts by mass of t-butyl peroxy-2-ethylhexyl carbonate which was used as organic peroxide, and had one minute half-life temperature of 166°C, 1.2 parts by mass of triallyl isocyanurate as the crosslinking aid, 0.3 parts by mass of 2-hydroxy-4-normal-octyloxy benzophenone as the ultraviolet absorbing agent, 0.2 parts by mass of bis(2,2,6,6-tetramethyl-4-piperidyl)sebacate as the light stabilizer, 0.1 part by mass of tris(2,4-di-tert-butylphenyl)phosphite as the Heat-resistance stabilizer 1, and 0.1 part by mass of octadecyl-3-(3,5-di-tert-butyl-4-hydroxyphenyl)propionate as the Heat-resistance stabilizer 2 were mixed with each other with respect to 100 parts by mass of an ethylene-vinyl acetate copolymer (EVA).

A coat-hanger type T dice (lip shape: 270×0.8 mm) was mounted in a single-axis extruder (diameter of screw of 20 mmφ, L/D=28) which is manufactured by Thermo Plastics Corporation. Molding was performed by using an embossing roll as a first cooling roll, and was performed at a roll temperature of 30°C, at a winding rate of 1.0 m/min under a condition of a dice temperature of 100°C. Thus, an embossing sheet (encapsulating material sheet) having a thickness of 500 μm was obtained. The porosity of the obtained sheet was 28%. Various evaluation results of the obtained encapsulating material sheet are shown in Table 2.

(Manufacturing examples 2 to 4)

An embossing sheet (encapsulating material sheet) was obtained similarly to the above-described Manufacturing example 1 except for being mixed as shown in Table 2. The porosities of the obtained sheets were 28%, respectively. Various evaluation results of the obtained encapsulating material sheets are shown in Table 2.

[Table 2]

|  | Manufacturing example 1 | Manufacturing example 2 | Manufacturing example 3 | Manufacturing example 4 |
|---|---|---|---|---|
| Cross-linkable resin | EVA | Synthesis example 1 | Synthesis example 2 | Synthesis example 3 |
| Organic peroxide | 1.0 | 1.0 | 1.0 | 0.7 |
| Crosslinking aid | 1.2 | 1.2 | 1.2 | 1.2 |
| Silane coupling agent | 0.5 | 0.5 | 0.5 | 0.5 |
| Ultraviolet absorbing agent | 0.3 | 0.3 | 0.3 | 0.3 |
| Heat-resistance stabilizer 1 | 0.1 | 0.1 | 0.1 | 0.1 |
| Heat-resistance stabilizer 2 | 0.1 | 0.1 | 0.1 | 0.1 |
| Light stabilizer | 0.2 | 0.2 | 0.2 | 0.2 |
| Storage elastic modulus G' (120°C) before cross-linking treatment [Pa] | 79 | 4.1 | $1.7 \times 10^2$ | $2.2 \times 10^2$ |
| Storage elastic modulus G' (90°C) after cross-linking treatment [Pa] | $1.9 \times 10^5$ | $4.6 \times 10^4$ | $2.4 \times 10^5$ | $2.8 \times 10^5$ |
| Linear expansion coefficient (-40°C to 0°C) [/°C] | $1.9 \times 10^{-4}$ | $2.2 \times 10^{-4}$ | $2.3 \times 10^{-4}$ | $2.0 \times 10^{-4}$ |
| Linear expansion coefficient (50°C to 90°C) [/°C] | $9.1 \times 10^{-4}$ | $1.3 \times 10^{-3}$ | $9.4 \times 10^{-4}$ | $9.4 \times 10^{-4}$ |

(Examples 1 to 5 and Comparative examples 1 to 4)

A combination of the first encapsulating material sheet 11 on the glass 22 side and the second encapsulating material sheet 12 on the PET film 21 side was used as a combination in Table 3. The bent amount of the combination was evaluated and the temperature cycle test was performed on the combination. The obtained results are shown in Table 3.

[Table 3]

| | Example 1 | Example 2 | Example 3 | Example 4 | Example 5 | Comparative example 1 | Comparative example 2 | Comparative example 3 | Comparative example 4 |
|---|---|---|---|---|---|---|---|---|---|
| First encapsulating material sheet | manufacturing example 1 | Manufacturing example 3 | Manufacturing example 3 | Manufacturing example 4 | Manufacturing example 4 | Manufacturing example 2 | Manufacturing example 1 | Manufacturing example 2 | Manufacturing example 2 |
| Second encapsulating material sheet | Manufacturing example 2 | Manufacturing example 1 | Manufacturing example 2 | Manufacturing example 2 | Manufacturing example 3 | Manufacturing example 2 | Manufacturing example 3 | Manufacturing example 1 | Manufacturing example 3 |
| $Log(P_1/P_2)$ [-] | 1.3 | 0.3 | 1.6 | 1.7 | 0.1 | 0 | -0.3 | -1.3 | -1.6 |
| $G_1 \times (\alpha_1/\alpha_2)$ [Pa] | $4.0 \times 10^4$ | $6.0 \times 10^4$ | $6.0 \times 10^4$ | $6.0 \times 10^4$ | $6.0 \times 10^4$ | $7.8 \times 10^3$ | $4.0 \times 10^4$ | $7.8 \times 10^3$ | $7.8 \times 10^3$ |
| Evaluation of bent amount | A | A | A | A | B | B | C | C | C |
| Temperature cycle test | A | A | A | A | B | C | C | C | C |

This application is based upon and claims the benefit of priority from Japanese Patent Application No. 2013-212631; filed October 10, 2013; the entire contents of which are incorporated herein by reference.

The present invention includes the following embodiments.

<Appendix>

(Appendix 1)

There is provided a sheet set for encapsulating a solar cell which is disposed between a light-receiving surface side protective member and a back surface side protective member, and is used for encapsulating a solar cell element and a wiring material. The sheet set for encapsulating a solar cell includes a first encapsulating material which is disposed on a light receiving side and is subjected to a cross-linking treatment, and a second encapsulating material which is disposed on a back surface side and is subjected to the cross-linking treatment.

A storage elastic modulus ($P_1$) of the first encapsulating material before the cross-linking treatment, and a storage elastic modulus ($P_2$) of the second encapsulating material before the cross-linking treatment satisfy a relationship of the following Expression (1), at 120°C when solid viscoelasticity is measured under conditions of a measurement temperature range of 25°C to 150°C, a frequency of 1.0 Hz, a temperature rising rate of 10°C /minute, and a shear mode.

$$\mathrm{Log}\ (P_1/P_2) > 0 \qquad \cdots\cdots\ (1)$$

(Appendix 2)

In the sheet set for encapsulating a solar cell in Appendix 1, a storage elastic modulus ($G_1$) of the first encapsulating material after the cross-linking treatment, a linear expansion coefficient ($\alpha_1$) thereof at a range of -40°C to 0°C, and a linear expansion coefficient ($\alpha_2$) thereof at a range of 50°C to 90°C satisfy a relationship of the following Expression (2), at 90°C when the solid viscoelasticity is measured under the conditions of the measurement temperature range of 25°C to 150°C, the frequency of 1.0 Hz, the temperature rising rate of 10°C/minute, and the shear mode.

$$G_1 \times (\alpha_1/\alpha_2) \geqq 2 \times 10^4 \qquad \cdots\cdots\ (2)$$

(Appendix 3)

In the sheet set for encapsulating a solar cell in Appendix 1 or 2, the first encapsulating material after the cross-linking treatment and the second encapsulating material after the cross-linking treatment respectively have a thickness of 0.2 mm to 1 mm.

(Appendix 4)

There is provided a solar cell module which uses the sheet set for encapsulating a solar cell according to any one of Appendixes 1 to 3.

**Claims**

1. A sheet set for encapsulating a solar cell, wherein
   the sheet set is disposed between a light-receiving surface side protective member and a back surface side protective member, and is used for encapsulating a solar cell element and a wiring material,
   the sheet set includes a first encapsulating material sheet disposed on a light-receiving surface side and a second encapsulating material sheet disposed on a back surface side, and
   a storage elastic modulus ($P_1$) of the first encapsulating material sheet before a cross-linking treatment and a storage elastic modulus ($P_2$) of the second encapsulating material sheet before the cross-linking treatment satisfy a relationship of the following Expression (1), at 120°C when solid viscoelasticity is measured under conditions of a measurement temperature range of 25°C to 180°C, a frequency of 1.0 Hz, a temperature rising rate of 10°C/minute, and a shear mode.

$$\mathrm{Log}\,(P_1/P_2) > 0 \qquad \cdots\cdots\ (1)$$

2. The sheet set for encapsulating a solar cell according to claim 1, wherein
a storage elastic modulus $(G_1)$, at 90°C when the solid viscoelasticity is measured under the conditions of the measurement temperature range of 25°C to 180°C, the frequency of 1.0 Hz, the temperature rising rate of 10°C/minute, and the shear mode, of the first encapsulating material sheet after the cross-linking treatment,
a linear expansion coefficient $(\alpha_1)$ at a range of -40°C to 0°C of the first encapsulating material sheet after the cross-linking treatment, and
a linear expansion coefficient $(\alpha_2)$ at a range of 50°C to 90°C of the first encapsulating material sheet after the cross-linking treatment,
satisfy a relationship of the following Expression (2).

$$G_1 \times (\alpha_1/\alpha_2) \geqq 2 \times 10^4 \qquad \cdots\cdots\ (2)$$

3. The sheet set for encapsulating a solar cell according to claim 1 or 2, wherein
the first encapsulating material sheet after the cross-linking treatment and the second encapsulating material sheet after the cross-linking treatment respectively have a thickness of 0.2 mm to 1 mm.

4. The sheet set for encapsulating a solar cell according to claim 1 or 2, wherein
at least one of the first encapsulating material sheet and the second encapsulating material sheet contains one or two types or more selected from a group consisting of an ethylene·$\alpha$-olefin copolymer and an ethylene-vinyl acetate copolymer as a cross-linkable resin.

5. The sheet set for encapsulating a solar cell according to claim 4, wherein
at least one of the first encapsulating material sheet and the second encapsulating material sheet contains organic peroxide, and
the content of the organic peroxide is equal to or greater than 0.1 parts by mass and equal to or smaller than 1.2 parts by mass with respect to 100 parts by mass of the cross-linkable resin.

6. The sheet set for encapsulating a solar cell according to claim 1 or 2, wherein
the storage elastic modulus $(P_1)$ is equal to or greater than $1.0 \times 10^{-1}$ Pa and equal to or smaller than $1.2 \times 10^6$ Pa, and
the storage elastic modulus $(P_2)$ is equal to or greater than $8.0 \times 10^{-2}$ Pa and equal to or smaller than $1.0 \times 10^6$ Pa.

7. The sheet set for encapsulating a solar cell according to claim 1 or 2, wherein
the light-receiving surface side protective member is a glass plate, and
the back surface side protective member is a thermoplastic resin film.

8. A solar cell module which uses the sheet set for encapsulating a solar cell according to claim 1 or 2.

9. The solar cell module according to claim 8, wherein
an encapsulating layer is provided between the light-receiving surface side protective member and the back surface side protective member, and the solar cell element is encapsulated in the encapsulating layer,
the encapsulating layer is formed by the sheet set for encapsulating a solar cell,
the encapsulating layer includes a first encapsulating layer and a second encapsulating layer,
the first encapsulating layer is obtained by cross-linking the first encapsulating material sheet,
the second encapsulating layer is obtained by cross-linking the second encapsulating material sheet,
the first encapsulating layer is provided between the light-receiving surface side protective member and the solar cell element, and
the second encapsulating layer is provided between the back surface side protective member and the solar cell element.

**10.** The solar cell module according to claim 9, wherein
the light-receiving surface side protective member is a glass plate, and
the back surface side protective member is a thermoplastic resin film.

Fig.1

Fig.2

Fig.3

Fig.4

## INTERNATIONAL SEARCH REPORT

| International application No. |
| --- |
| PCT/JP2014/076948 |

A. CLASSIFICATION OF SUBJECT MATTER
*H01L31/048*(2014.01)i, *B32B7/02*(2006.01)i

According to International Patent Classification (IPC) or to both national classification and IPC

B. FIELDS SEARCHED

Minimum documentation searched (classification system followed by classification symbols)
H01L31/04-31/056, 31/18-31/20, B32B7/02

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | WO 2011/093383 A1 (Sanyo Electric Co., Ltd.),<br>04 August 2011 (04.08.2011),<br>paragraphs [0032] to [0063], [0099] to [0116];<br>fig. 1<br>& JP 2011-159711 A    & US 2012/0285536 A1<br>& EP 2530737 A1 | 1,3,4,6-8<br>2,5,9,10 |
| Y | JP 2013-118302 A (Bridgestone Corp.),<br>13 June 2013 (13.06.2013),<br>paragraphs [0023] to [0031]; fig. 1<br>(Family: none) | 2,5,9,10 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>15 December 2014 (15.12.14) | Date of mailing of the international search report<br>06 January 2015 (06.01.15) |
| --- | --- |
| Name and mailing address of the ISA/<br>Japan Patent Office | Authorized officer |
| Facsimile No. | Telephone No. |

Form PCT/ISA/210 (second sheet) (July 2009)

**INTERNATIONAL SEARCH REPORT**

International application No.

PCT/JP2014/076948

C (Continuation).   DOCUMENTS CONSIDERED TO BE RELEVANT

| Category* | Citation of document, with indication, where appropriate, of the relevant passages | Relevant to claim No. |
|---|---|---|
| A | WO 2013/128861 A1  (Mitsui Chemicals Tohcello, Inc.),<br>06 September 2013 (06.09.2013),<br>paragraphs [0164] to [0179]; fig. 1<br>& JP 5465813 B          & CN 104137277 A<br>& TW 201338175 A | 1-10 |
| A | WO 2013/112874 A1  (DOW CORNING CORP.),<br>01 August 2013 (01.08.2013),<br>paragraphs [0018] to [0065]; fig. 2 to 5<br>& TW 201342645 A | 1-10 |

Form PCT/ISA/210 (continuation of second sheet) (July 2009)

**EP 3 057 136 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2010053298 A
- JP 2006210906 A
- WO 2011162324 A
- JP 2001352089 A
- JP 2013212631 A